# EUROPEAN PATENT APPLICATION

(11) **EP 4 679 961 A1**
(43) Date of publication of application: **14.01.2026**
(21) Application number: 24187376.9
(22) Date of filing: 09.07.2024
(51) Int. Cl.: H05K 9/00, H05K 7/20

(54) **HEATSINK**

(71) Applicant: Aptiv Technologies AG, 8200 Schaffhausen (CH)
(72) Inventor: ADAMCZYK, Maciej, 30-499 Kraków (PL); KAPERA, Natalia, 30-701 Kraków (PL); POREDA, Witold, 32-050 Skawina (PL); PUKA, Michal, 32-700 Bochnia (PL); WYSOCKA, Natalia, 32-065 Wola Filipowska (PL); ZADWORNY, Bartlomiej, 37-600 Lubaczów (PL)
(74) Representative: Manitz Finsterwald Patent- und Rechtsanwaltspartnerschaft mbB

(57) **Abstract**

A heatsink is configured to be assembled with a PCB and comprises a heatsink body having a bottom and a sidewall with an end surface configured to face the PCB when the heatsink and the PCB are assembled, and a metal gasket in the heatsink body, the metal gasket having a plurality of gasket fingers provided along a perimeter of the heatsink body. The end surface is a flat surface extending continuously along the entire perimeter of the heatsink body.

## Description

The present invention relates to a heatsink, particularly for an automotive radar, to an assembly comprising a printed circuit board and a heatsink, and to an electrical component, particularly a radar.

Automotive radars require heatsinks that provide EMC protection (electromagnetic compatibility). Such heatsinks typically include a main body and a metal gasket with gasket fingers that are pressed against a printed circuit board (PCB). The main body usually has hard stops commonly provided on the perimeter of the main body in the form of projections of the material of the main body.

These hard stops serve to avoid excessive compression of the gasket fingers during assembly of the heatsink with the PCB. However, after assembly, the hard stops do not provide a suitable electrical contact with the PCB which compromises EMC protection. If hard stops are provided so as to be comparably small in order to improve EMC protection, this compromises heatsink stiffness. Additionally, since the contact area between the PCB and hard stops is rather small, PCB strains are created.

Accordingly, there is a need for a heatsink providing improved EMC performance while maintaining or improving heatsink stiffness and PCB strains.

The present invention provides a heatsink, particularly for an automotive radar, according to the independent claim. Embodiments are given in the dependent claims, the description and the drawings.

The heatsink according to the invention is configured to be assembled with a printed circuit board, hereinafter also referred to as "PCB", and is particularly a heatsink for an automotive radar. The heatsink comprises a heatsink body having a bottom and a sidewall with an end surface configured to face the PCB when the heatsink and the PCB are assembled, and a metal gasket in the heatsink body, the metal gasket having a plurality of gasket fingers provided along a perimeter of the heatsink body. The end surface is a flat surface extending continuously along the entire perimeter of the heatsink body.

Since the end surface of the sidewall is a continuous, flat surface along the entire perimeter, the end surface is particularly a surface that is not interrupted by other features such as projections.

The end surface may or may not directly contact the PCB when the heatsink and the PCB are assembled. The metal gasket may be fitted in the heatsink body so that it directly contacts at least one of the bottom and the sidewall, or both. Thus, the metal gasket may have a bottom portion at the bottom of the heatsink body and one or more sidewall portions extending at the sidewall of the heatsink body. The gasket fingers may protrude from an edge of the metal gasket, particularly from edges of the sidewall portions. In particular, the gasket fingers may extend in the vicinity of the end surface, for example approximately parallel to the end surface or with an angle equal to or less than 30° to the end surface.

The heatsink body including the bottom and the sidewall may have a cup-shaped design. For example, the heatsink body may be produced by deep drawing.

The heatsink body may have an outwardly projecting flange on which the end surface is provided, that is a flange projecting from an end of the sidewall to the outside of the heatsink body. The flange may be approximately parallel to the bottom of the heatsink body.

The flange may have a constant material thickness along the perimeter of the heatsink body. Particularly, the end surface may be free of any hard stops projecting therefrom. Thus, the proposed design of the heatsink body has no hard stops. Due to the absence of hard stops, gasket fingers can be provided along the entire perimeter of the heatsink body that would otherwise interfere with the presence of hard stops.

The gasket fingers may be configured to be in direct contact with both the end surface and the PCB when the heatsink and the PCB are assembled. Instead of providing hard stops, the gasket fingers may be pressed against the heatsink body, particularly the end surface of the sidewall, which improves EMC protection. At the same time, a pressing force between the PCB and the heatsink is applied and distributed over the entire perimeter of the heatsink body, which reduces PCB strains.

According to one aspect, each gasket finger has a flat first contact portion configured to directly contact either the end surface or the PCB when the heatsink and the PCB are assembled and a second contact portion protruding from the first contact portion and configured to directly contact the other one of the end surface and the PCB when the heatsink and the PCB are assembled. Accordingly, the gasket fingers have a design with a protrusion which forms the second contact portion.

The sidewall may have a generally rectangular shape with four side sections in a top view, wherein a transition section is provided between each two adjacent side sections of the rectangle and each transition section has a flat contact surface facing an interior of the heatsink body. The side sections represent the four sides of the rectangle, i.e. adjacent side sections extend relative to each other at an angle of approximately 90°. With the transition sections having the flat contact surface, it is possible that the metal gasket and also the gasket fingers are provided not only at the four side sections, but also at the transition sections. Each transition section may be arranged at an angle of approximately 135° to the adjacent side sections of the rectangle.

According to one aspect, the invention further relates to an assembly comprising a PCB and the heatsink assembled with the PCB. In the assembly, the gasket fingers may be in direct contact with both the end surface and the PCB.

According to a further aspect, the invention relates to an electrical component, particularly a radar, more particularly an automotive radar, comprising a housing and a cover for closing the housing, the above-mentioned assembly being arranged in the housing.

Exemplary embodiments and functions of the present invention are described herein in conjunction with the following, schematic drawings. In the drawings,
- Fig. 1: is a perspective view of a heatsink according to an embodiment of the present invention;
- Fig. 2: is a cross-sectional view of the heatsink shown in Fig. 1 and a PCB before assembly; and
- Fig. 3: is a cross-sectional view of the heatsink and a PCB shown in Fig. 2 after assembly.

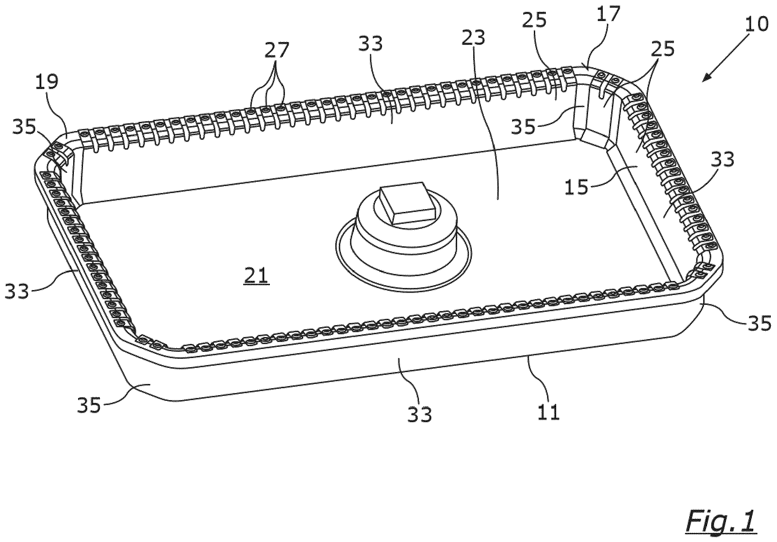

Figs. 1 to 3 show an embodiment, and particularly a heatsink 10 and a PCB 50, of the present invention in which a housing and a cover have been omitted. However, when assembled, the heatsink 10 and the PCB 50 are intended to be placed in a housing which is closed by a cover (radome).

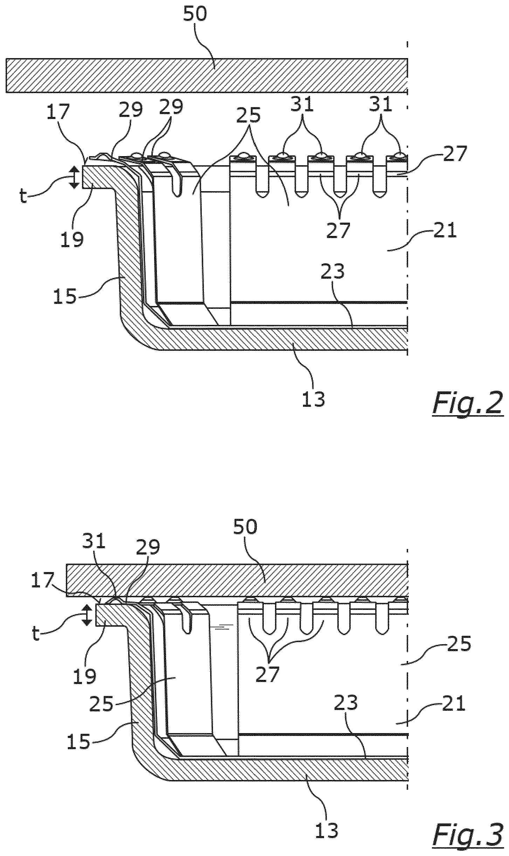

Particularly Fig. 1 shows that the heatsink 10 comprises a heatsink body 11 which has a bottom 13 and a sidewall 15. At the top of the sidewall 15, a flange 19 projects to the outside of the heatsink body 11, on which a flat end surface 17 is provided that faces, but does not contact the PCB 50 in an assembled state, see Fig. 3.

Both the flange 19 having a constant thickness t and the end surface 17 extend continuously along the entire perimeter of the heatsink body 11. The end surface 17 is flat and continuous along the entire perimeter. Particularly, in the present embodiment, the end surface 17 is not interrupted by any protrusion or recess and free of any hard stops projecting from the end surface 17.

As can be seen particularly in Fig. 1, the sidewall 15 has, in a top view, a generally rectangular shape with four rectangular side sections 33. Transition sections 35 are provided between each two adjacent side sections 33 so as to interconnect the respective side sections at an angle of approximately 135° to the adjacent side sections 33 of the rectangle.

A metal gasket 21 is provided in the heatsink body 11. The metal gasket 21 has a bottom portion 23 at the bottom 13 of the heatsink body 11 and several sidewall portions 25 extending at the sidewall 15 of the heatsink body 11, particularly at both the side sections 33 and the transition sections 35. Each side section 33 and each transition section 35 has a flat, non-curved contact surface facing an interior of the heatsink body 11 for the respective sidewall portion 25. Further, the metal gasket 21 has a plurality of gasket fingers 27 which protrude from the edges of the sidewall portions 25 so as to extend in the vicinity of the end surface 17, see particularly Fig. 2. The gasket fingers 27 curve around an upper part of the sidewall 15 of the heatsink body 11 including the end surface 17. The gasket fingers 27 are provided and distributed along the perimeter of the heatsink body 11. Particularly, the gasket fingers are provided at both the side sections 33 and the transition sections 35.

As can be seen in Fig. 3, each gasket finger 27 has a flat first contact portion 29 that directly contacts the end surface 17 when the heatsink 10 and the PCB 50 are assembled and a second contact portion 31 bulging from the first contact portion 29 and contacting the PCB 50 when the heatsink 10 and the PCB 50 are assembled.

Accordingly, the present invention particularly proposes a design of a heatsink that is free of hard stops. Instead, the gasket fingers are pressed against the heatsink body during assembly. Thereby, EMC protection is improved. Further, a reduction of stiffness of the hard stops can be avoided due to the design. Since the distance between the heatsink body and the PCB is equal to the thickness of the gasket fingers, the gasket fingers are compressed between the heatsink body and the PCB, and force transmission between the PCB and the heatsink body does not only take place at the hard stops, but is distributed over the entire perimeter of the heatsink body which reduces PCB strains.

### Reference numeral list

- 10: heatsink
- 11: heatsink body
- 13: bottom
- 15: sidewall
- 17: end surface
- 19: flange
- 21: metal gasket
- 23: bottom portion
- 25: sidewall portion
- 27: gasket finger
- 29: first contact portion
- 31: second contact portion
- 33: side section
- 35: transition section
- 50: printed circuit board

- t: thickness

## Claims

1. A heatsink (10) configured to be assembled with a printed circuit board (50), PCB, particularly for an automotive radar, the heatsink (10) comprising a heatsink body (11) having a bottom (13) and a sidewall (15) with an end surface (17) configured to face the PCB (50) when the heatsink (10) and the PCB (50) are assembled, and
a metal gasket (21) in the heatsink body (11), the metal gasket (21) having a plurality of gasket fingers (27) provided along a perimeter of the heatsink body (11),
wherein the end surface (17) is a flat surface extending continuously along the entire perimeter of the heatsink body (11).

2. The heatsink (10) according to claim 1,
**characterized in that** the heatsink body (11) has an outwardly projecting flange (19) on which the end surface (17) is provided.

3. The heatsink (10) according to claim 2,
**characterized in that** the flange (19) has a constant thickness (t) along the perimeter of the heatsink body (11).

4. The heatsink (10) according to any one of claims 1 to 3,
**characterized in that** the end surface (17) is free of any hard stops projecting therefrom.

5. The heatsink (10) according to any one of claims 1 to 4,
**characterized in that** the gasket fingers (27) are configured to be in direct contact with both the end surface (17) and the PCB (50) when the heatsink (10) and the PCB (50) are assembled.

6. The heatsink (10) according to any one of claims 1 to 5,
**characterized in that** each gasket finger (27) has a flat first contact portion (29) configured to directly contact either the end surface (17) or the PCB (50) when the heatsink (10) and the PCB (50) are assembled and a second contact portion (31) protruding from the first contact portion (29) and configured to directly contact the other one of the end surface (17) and the PCB (50) when the heatsink (10) and the PCB (50) are assembled.

7. The heatsink (10) according to any one of claims 1 to 6,
**characterized in that** the sidewall (15) has a generally rectangular shape with four side sections (33) in a top view, wherein a transition section (35) is provided between each two adjacent side sections (33) of the rectangle and each transition section (35) has a flat contact surface facing an interior of the heatsink body (11).

8. The heatsink (10) according to claim 7,
**characterized in that** each transition section (35) is arranged at an angle of approximately 135° to the adjacent side sections (33) of the rectangle.

9. An assembly comprising a printed circuit board (50), PCB, and the heatsink (10) according to any one of claims 1 to 8 assembled with the PCB (50).

10. The assembly according to claim 9, wherein the gasket fingers (27) are in direct contact with both the end surface (17) and the PCB (50).

11. An electrical component, particularly a radar, comprising
a housing,
the assembly according to claim 9 or 10 arranged in the housing, and
a cover for closing the housing.
